# EUROPEAN PATENT SPECIFICATION

(11) **EP 2 779 222 B1**
(45) Date of publication and mention of the grant of the patent: **16.08.2017**
(21) Application number: 14158323.7
(22) Date of filing: 07.03.2014
(51) Int. Cl.: H01L 21/67, H01L 21/677, H01L 21/687

(54) **Substrate treatment systems using supercritical fluid**
Systeme zur Behandlung von Substraten mit superkritischen Flüssigkeiten
Système de traîtement de substrats utilisant des fluides supercritiques.

(30) Priority: 12.03.2013 KR 20130026254; 15.03.2013 US 201313844149
(43) Date of publication of application: 17.09.2014
(60) Divisional application: 17177554.7
(73) Proprietor: Samsung Electronics Co., Ltd., Suwon-si Gyeonggi-do 443-742 (KR)
(72) Inventor: Cho, Yong-Jhin, 445-789 Hwaseong-si, Gyeonggi-do (KR); Ko, Yongsun, 441-820 Suwon-si, Gyeonggi-do (KR); Kim, Kyoungseob, 440-300 Suwon-si, Gyeonggi-do (KR); Kim, Kwangsu, 134-772 Seoul (KR); Kim, SeokHoon, 461-162 Seongnam-si, Gyeonggi-do (KR); Oh, Jung-Min, 405-765 Incheon (KR); Lee, Kuntack, 442-070 Suwon-si, Gyeonggi-do (KR); Jang, Wonho, 446-904 Yongin-si, Gyeonggi-do (KR); Jun, Yongmyung, 445-774 Hwaseong-si, Gyeonggi-do (KR)
(74) Representative: Kuhnen & Wacker

(56) References cited:
- WO-A2-03/107396
- US-A1- 2012 048 304

## Description

### BACKGROUND

The inventive concept relates to substrate treatment systems and, more particularly, to substrate treatment systems capable of performing a supercritical process.

From WO 03/107396 A2 there is known an apparatus for processing a microelectronic substrate comprising a main chamber and a movable boundary. The main chamber comprises a main chamber wall enclosing a main chamber interior. The movable boundary is movable between a first position and a second position. At the first position, the movable boundary at least partially defines a sub-chamber in which a substrate can be processed. The sub-chamber is fluidly isolated from the main chamber interior, and provides an environment suitable for a high-pressure processing of the substrate such as cleaning or surface preparation. The sub-chamber can be maintained at a high pressure while the main chamber is maintained at either a low pressure, an atmospheric pressure, or at a vacuum; the apparatus can be directly coupled to an external substrate handling and/or fabrication module, such that the main chamber interior provides a buffer between the sub-chamber and the external module. At the second position of the movable boundary, the substrate can be loaded into or removed from the apparatus, such as by transfer to or from any external module provided.

A supercritical fluid is any substance at a temperature and pressure above its critical point, where distinct liquid and gas phases do not exist. Thus, it has properties of a gas and a liquid. Supercritical processes using the supercritical fluid may be used in the semiconductor industry to obtain various advantages. For example, the supercritical processes may be used for a substrate drying process, a cleaning process, and/or an etching process. When a high-pressure supercritical fluid is supplied into a process chamber, it may rapidly expand. As a result, the temperature and the solubility of the supercritical fluid may be reduced such that a small amount of impurities included in the supercritical fluid may be undesirably condensed or deposited. The condensed or deposited impurities may re-contaminate a substrate. Thus, particle management may be important during the supercritical processes.

### SUMMARY

Embodiments of the inventive concept may provide substrate treatment systems using supercritical fluid for substantially reducing contaminating particles or impurities.

Embodiments of the inventive concept may also provide substrate treatment systems capable of improving supercritical process capability.

Embodiments of the inventive concept may also provide substrate treatment systems capable of performing a supercritical process with reduced deterioration of the properties of the supercritical fluid.
The object of the invention is attained by an apparatus for treating a substrate according to claim 1. Further developments of the invention are specified in the dependent claims.

### BRIEF DESCRIPTION OF THE DRAWINGS

The inventive concept will become more apparent in view of the attached drawings and accompanying detailed description.
FIG. 1A is a schematic diagram illustrating a substrate treatment system according to an embodiment of the inventive concept;
FIG. 1B is a cross-sectional view illustrating a process chamber in a substrate treatment system according to an embodiment of the inventive concept;
FIG. 1C is a plan view illustrating the inside of a process chamber in a substrate treatment system according to an embodiment of the inventive concept;
FIGS. 1D to 1J are cross-sectional views illustrating modified examples of the process chamber of FIG. 1B;
FIG. 2A is a schematic diagram illustrating a substrate treatment system according to another embodiment of the inventive concept;
FIG. 2B is a schematic diagram illustrating a substrate treatment system according to still another embodiment of the inventive concept;
FIG. 3A is a schematic diagram illustrating a substrate treatment system according to a comparative example (not part of the claimed invention);
FIG. 3B is a cross-sectional view illustrating a process chamber and an expansion chamber in a substrate treatment system according to the comparative example of Fig. 3A;
FIG. 4A is a schematic diagram illustrating a substrate treatment system according to yet another embodiment of the inventive concept;
FIG. 4B is a cross-sectional view illustrating a process chamber and an expansion chamber in a substrate treatment system according to yet another embodiment of the inventive concept;
FIGS. 5A-5C are cross-sectional views illustrating a process chamber during different stages of a supercritical process according to some embodiments of the present disclosure;
FIG. 5D illustrates a magnified cross-sectional view of a supporting unit SU according to one embodiment;
FIG. 6 is a flow chart illustrating a method of treating a substrate using a supercritical fluid according to some embodiments of the present disclosure;
FIG. 7 is a diagram illustrating inventive concepts; and
FIG. 8 is a graph showing effects of inventive concepts.

### DETAILED DESCRIPTION OF THE EMBODIMENTS

The inventive concept will now be described more fully hereinafter with reference to the accompanying drawings, in which exemplary embodiments of the inventive concept are shown. The comparative example does not form part of the claimed invention but serves for a better understanding thereof. The advantages and features of the inventive concept and methods of achieving them will be apparent from the following exemplary embodiments that will be described in more detail with reference to the accompanying drawings. It should be noted, however, that the inventive concept is not limited to the following exemplary embodiments, and may be implemented in various forms. Accordingly, the exemplary embodiments are provided only to disclose the inventive concept and let those skilled in the art know the category of the inventive concept. In the drawings, embodiments of the inventive concept are not limited to the specific examples provided herein and are exaggerated for clarity.

The terminology used herein is for the purpose of describing particular embodiments only and is not intended to limit the invention. As used herein, the singular terms "a," "an" and "the" are intended to include the plural forms as well, unless the context clearly indicates otherwise. As used herein, the term "and/or" includes any and all combinations of one or more of the associated listed items. It will be understood that when an element is referred to as being "connected" or "coupled" to another element, it may be directly connected or coupled to the other element or intervening elements may be present.

Similarly, it will be understood that when an element such as a layer, region or substrate is referred to as being "on" another element, it can be directly on the other element or intervening elements may be present. It will be further understood that the terms "comprises", "comprising," "includes" and/or "including", when used herein, specify the presence of stated features, integers, steps, operations, elements, and/or components, but do not preclude the presence or addition of one or more other features, integers, steps, operations, elements, components, and/or groups thereof.

Additionally, the embodiment in the detailed description will be described with sectional views as ideal exemplary views of the inventive concept. Accordingly, shapes of the exemplary views may be modified according to manufacturing techniques and/or allowable errors. Therefore, the embodiments of the inventive concept are not limited to the specific shape illustrated in the exemplary views, but may include other shapes that may be created according to manufacturing processes. Areas exemplified in the drawings have general properties, and are used to illustrate specific shapes of elements. Thus, this should not be construed as limited to the scope of the inventive concept.

It will be also understood that although the terms first, second, third etc. may be used herein to describe various elements, these elements should not be limited by these terms. These terms are only used to distinguish one element from another element. Thus, a first element in some embodiments could be termed a second element in other embodiments without departing from the teachings of the present invention. Exemplary embodiments of aspects of the present inventive concept explained and illustrated herein include their complementary counterparts. The same reference numerals or the same reference designators denote the same elements throughout the specification.

Moreover, exemplary embodiments are described herein with reference to cross-sectional illustrations and/or plane illustrations that are idealized exemplary illustrations. Accordingly, variations from the shapes of the illustrations as a result, for example, of manufacturing techniques and/or tolerances, are to be expected. Thus, exemplary embodiments should not be construed as limited to the shapes of regions illustrated herein but are to include deviations in shapes that result, for example, from manufacturing. For example, an etching region illustrated as a rectangle will, typically, have rounded or curved features. Thus, the regions illustrated in the figures are schematic in nature and their shapes are not intended to illustrate the actual shape of a region of an apparatus and are not intended to limit the scope of example embodiments.

### [An embodiment of a substrate treatment system]

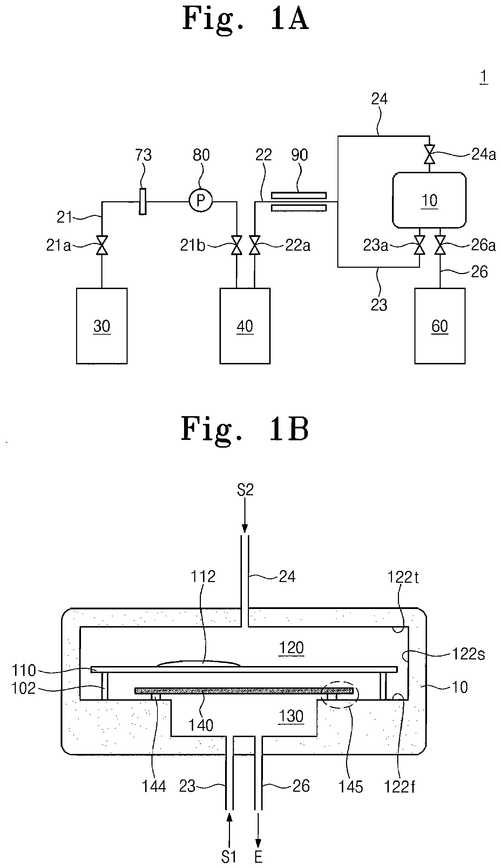

FIG. 1A is a schematic diagram illustrating a substrate treatment system according to an embodiment of the inventive concept.

Referring to FIG. 1A, a substrate treatment system 1 may be an apparatus for performing a supercritical process to treat a substrate by a supercritical fluid. In the present disclosure, the supercritical process may mean a drying process where a wafer is dried after being subject to a cleaning or other wafer fabrication processes. The supercritical process may also mean a cleaning process where the wafer is cleaned using a supercritical fluid containing additives such as a surfactant after the certain wafer fabrication process. As discussed above, the supercritical fluid may be any substance at the temperature and pressure above its critical point, where distinct liquid and gas phases do not exist. The supercritical fluid may have properties between those of a gas and a liquid. For, example, the supercritical fluid may have diffusibility, viscosity, and surface tension equal to or similar to those of a gas. Additionally, the supercritical fluid may have solubility equal to or similar to that of a liquid. In general, the supercritical fluid may include CO₂, H₂O, CH₄, C₂H₆, C₃H₈, C₂H₄, C₂H₂, C₂H₃OH, C₂HₛOH, SF₆, or C₃H₈O.

In an embodiment, the substrate treatment system 1 may include a process chamber 10 where the supercritical process is performed and a supplying device 30 where at least one supercritical fluid is stored. The supercritical fluid may be supplied into the process chamber 10 from the supplying device 30. The supplying device 30 may pressurize and heat a fluid above its critical point to form the supercritical fluid, and then it may store the supercritical fluid therein. The substrate treatment system 1 may further include a buffer tank 40 for stably supplying the supercritical fluid into the process chamber 10. The substrate treatment system 1 may further include a first supply pipe 21, a second supply pipe 22, a third supply pipe 23, a fourth supply pipe 24, and an exhaust pipe 26. The first supply pipe 21 may have valves 21 and 21b which control the flow of the supercritical fluid from the supplying device 30 to the buffer tank 40. The second supply pipe 22 may have a valve 22a which controls the flow of the supercritical fluid from the buffer tank 40 to the process chamber 10. The third supply pipe 23 and the fourth supply pipe 24 may diverge from the second supply pipe 22 and be connected to the process chamber 10. The third supply pipe 23 and the fourth supply pipe 24 may have valves 23a and 24a, respectively. The exhaust pipe 26 may have a valve 26a for exhausting the supercritical fluid from the process chamber 10.

In an embodiment, the substrate treatment system 1 may further include a pump 80, a heating jacket 90, and a recovery tank 60. The pump 80 may be installed on the first supply pipe 21 to provide the supercritical fluid with a pressure. The heating jacket 90 may be installed on the second supply pipe 22 to provide the supercritical fluid with a heat so as to maintain a supercritical state of the supercritical fluid. The recovery tank 60 may store the supercritical fluid exhausted through the exhaust pipe 26.

In some embodiments, the substrate treatment system 1 may also include a condenser 73 upstream of the pump 80 such that the supercritical fluid can be condensed by the condenser 73 before the supercritical fluid is provided or injected to the process chamber 10. With the condenser 73, some of the impurities contained in the supercritical fluid may therefore be removed by condensation before the supercritical fluid reaches the process chamber 10.

In the present embodiment, the supercritical fluid may be sequentially supplied through the third supply pipe 23 and the fourth supply pipe 24 into the process chamber 10 to perform the supercritical process. For example, the supercritical fluid may be supplied through the third supply pipe 23 into the process chamber 10 so as to make the supercritical state in the process chamber 10, and then the supercritical fluid may be supplied through the fourth supply pipe 24 into the process chamber 10 so as to perform the supercritical process. If the supercritical process is performed after the internal environment of the process chamber 10 is changed into the supercritical state, it is possible to substantially reduce impurities or particles caused by expansion of the supercritical fluid. This will be described in more detail with reference to FIG. 1B. The supercritical fluid exhausted from the process chamber 10 through the exhaust pipe 26 may be released into the atmosphere or stored in the recovery tank 60.

### [An embodiment of a process chamber]

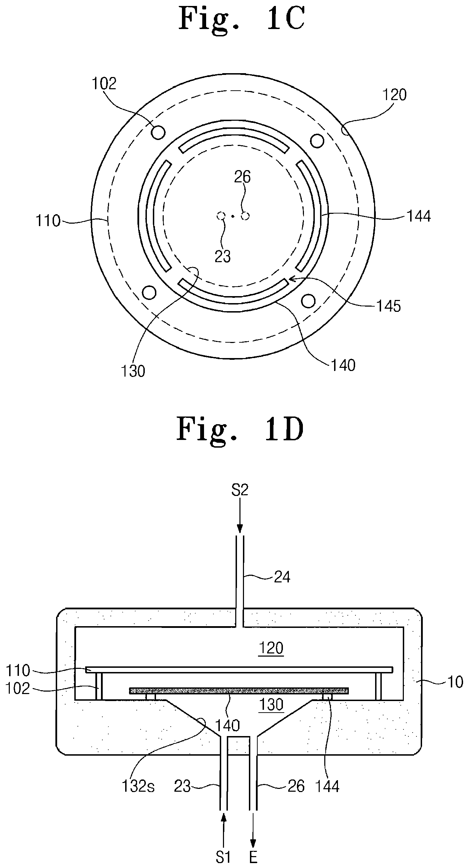

FIG. 1B is a cross-sectional view illustrating a process chamber in a substrate treatment system according to an embodiment of the inventive concept. FIG. 1C is a plan view illustrating the inside of a process chamber in a substrate treatment system according to an embodiment of the inventive concept.

Referring to FIGS. 1B and 1C, the process chamber 10 may include a pre-supercritical process zone 130 and a supercritical process zone 120. The third supply pipe 23 may be connected to the pre-supercritical process zone 130 for first supplying of the supercritical fluid and the exhaust pipe 26 may be connected to the pre-supercritical process zone 130 for exhausting of the supercritical fluid. The fourth supply pipe 24 may be connected to the supercritical process zone 120 for second supplying of the supercritical fluid. A substrate 110 may be provided into the supercritical process zone 120.

A portion of a bottom surface 122f of the supercritical process zone 120 or the bottom portion of the process chamber 10 may be recessed to define the pre-supercritical process zone 130. A blocking plate 140 may cover the pre-supercritical process zone 130. The blocking plate 140 may divide the internal region of the process chamber 10 into the pre-supercritical process zone 130 and the supercritical process zone 120. The blocking plate 140 may be supported by a plurality of supporting parts 144 disposed on the bottom surface 122f, so that the blocking plate 140 may be spaced apart from the bottom surface 122f. The blocking plate 140 may have a circular shape in plan view, and the supporting parts 144 may be disposed along a circumferential edge of the blocking plate 140 and be spaced apart from each other. Thus, one or more passages 145 may be defined by the blocking plate 140, the bottom surface 122f, and the supporting parts 144. The passage 145 may connect the pre-supercritical process zone 130 to the supercritical process zone 120. A plurality of supporting pins 102 may be provided on the bottom surface 122f along a circumferential edge of the substrate 110. The supporting pins 102 may be spaced apart from each other. The substrate 110 may be supported by the supporting pins 102.

Each of the pre-supercritical process zone 130 and the supercritical process zone 120 may have a volume of a circular cylinder-shape having a circular cross section in plan view. The pre-supercritical process zone 130 may have a volume smaller than that of the supercritical process zone 120. For example, the volume of the pre-supercritical process zone 130 may have a range of about 5% to about 20% of the volume of the supercritical process zone 120. A vertical distance of the passage 145 may be defined as a distance between the blocking plate 140 and the bottom surface 122f. The vertical distance of the passage 145 may have a range of about 0.1% to about 20.0%, more preferably, 1 to 10% of a sum of a height of the supercritical process zone 120 and a height of the pre-supercritical process zone 130. A horizontal distance of the passage 145 may be defined as a straight or circumferential distance between the supporting parts 144 adjacent to each other. The horizontal distance of the passage 145 may be equal to or similar to the vertical distance of the passage 145. The passage 145 may function as an expansion nozzle. However, the inventive concept is not limited to the shape and the numerical values of the elements described above.

In another embodiment, a portion of a top surface 122t of the supercritical process zone 120 may be recessed to define the pre-supercritical process zone 130. In still another embodiment, a portion of a sidewall 122s of the supercritical process zone 120 may be recessed to define the pre-supercritical process zone 130.

### [An embodiment of substrate treatment]

Referring to FIGS. 1A, 1B, and 1C, the substrate 110 may be loaded into the supercritical process zone 120, and then the supercritical fluid may be first supplied into the process chamber 10 to create the supercritical state in the process chamber 10. Subsequently, the supercritical fluid may be second supplied into the process chamber 10 to perform the supercritical process (e.g., a substrate drying process). The supercritical fluids may be supplied from the supplying device 30. The supercritical fluids may be the same material as each other. Alternatively, the first supplied supercritical fluid may be different from the second supplied supercritical fluid.

The substrate 110 may be provided into the supercritical process zone 120. For example, after the substrate 110 is cleaned, the substrate 110 may be provided into the supercritical process zone 120 for removing a cleaning solution remaining on the substrate 110. The substrate 110 may be a metal substrate, a semiconductor substrate, or an insulation substrate. For example, the substrate 110 may be a bare wafer, or a processed semiconductor wafer on which integrated circuits are formed.

The supercritical fluid (e.g., CO₂) provided from the supplying device 30 may be supplied into the pre-supercritical process zone 130 of the process chamber 10 through the third supply pipe 23 (S1). The supercritical fluid may be continuously supplied into the pre-supercritical process zone 130 until a flow rate of the supercritical fluid reaches a desired value. The pre-supercritical process zone 130 may be pressurized from a vacuum or an atmospheric pressure to a supercritical pressure state by the supply of the supercritical fluid. The supercritical fluid may be expanded (first expansion) at an end portion of the third supply pipe 23 (i.e., a boundary region between the third supply pipe 23 and the pre-supercritical process zone 130). In one embodiment, the supercritical fluid may be adiabatically expanded during the first expansion. Due to the expansion of the supercritical fluid, a temperature and a pressure of the supercritical fluid may be reduced in the pre-supercritical process zone 130. Since the temperature of the supercritical fluid is reduced, the solubility of the supercritical fluid may be reduced. Even though the supercritical fluid may have high purity (e.g., 99.99%), it may contain a small amount of impurities or particles. The impurities may be condensed by the reduction of the temperature and the reduction of solubility. The condensed impurities may be adsorbed on an inner surface or a wall of the pre-supercritical process zone 130, or the blocking plate 140 may block the condensed impurities such that the condensed impurities may not be moved into the supercritical process zone 120 so as to be piled up in the pre-supercritical process zone 130.

According to some embodiments, in the present disclosure, a supplying device may not just mean the supplying device 30, but may include various structures or elements configured to supply the supercritical fluid to a supercritical process chamber or apparatus.

The supercritical fluid first expanded in the pre-supercritical process zone 130 may be moved into the supercritical process zone 120 through the passage 145. The passage 145 may function as the expansion nozzle, so that the supercritical fluid moved into the supercritical process zone 120 may be expanded again (second expansion). In the present embodiment, the supercritical process zone 120 may be changed into the supercritical state by the limited volumes of the pre-supercritical process zone 130 and the supercritical process zone 120 and/or the continuous supply of the supercritical fluid. As the supercritical fluid is expanded again (second expansion) to cause the impurity condensation phenomenon. However, because the impurities in the supercritical fluid are trapped or filtered by the first expansion of the supercritical fluid in the pre-supercritical process zone 130, it may be possible to substantially reduce the impurity condensation phenomenon caused by the second expansion of the supercritical fluid in the supercritical process zone 120.

In the state that the supercritical process zone 120 is in the supercritical state, the supercritical fluid (e.g., CO₂) provided from the supplying device 30 may be supplied into the supercritical process zone 120 through the fourth supply pipe 24 (S2). The supercritical fluid supplied into the supercritical process zone 120 of the supercritical state may maintain the properties of the supercritical fluid. A removal object 112 (e.g., a cleaning solution such as isopropyl alcohol (IPA)) remaining on the substrate 110 may be dissolved by the supercritical fluid, so as to be removed from the substrate 110.

Differently from the present embodiment, if the supercritical fluid is supplied into a process chamber not having the pre-supercritical process zone according to some embodiments of the present disclosure, the temperature and the solubility of the supercritical fluid may be reduced by the expansion of the supercritical fluid. As a result, the impurities in the supercritical fluid may be condensed therein to contaminate the substrate. Additionally, the reduction of the solubility of the supercritical fluid may cause deterioration of its drying ability. However, according to the present embodiment, because the supercritical fluid may be first supplied into the pre-supercritical process zone 130 to filter the impurities, the supercritical process zone 120 may be maintained in the cleaned supercritical state. As a result, since the supercritical process zone 120 may be in the supercritical state by the first supply of the supercritical fluid, it may be possible to substantially reduce the rapid expansion of the supercritical fluid and/or rapid reduction of the solubility of the supercritical fluid during the second supplying of the supercritical fluid.

If the drying process is finished, the supercritical fluid containing the removal object 112 may be exhausted from the process chamber 10 through the exhaust pipe 26 (E). According to the present embodiment, the exhaust pipe 26 may be connected to the pre-supercritical process zone 130. Thus, the supercritical fluid containing the removal object 112 may be moved into the exhaust pipe 26 from the supercritical process zone 120 via the pre-supercritical process zone 130. At this time, a contaminant (e.g., the condensed impurities) existing in the pre-supercritical process zone 130 may be exhausted along with the supercritical fluid. In an embodiment, since the third supply pipe 23 as the supply path of the supercritical fluid to the pre-supercritical process zone 130 is equipped separately from the exhaust pipe 26 as the exhaust path of the supercritical fluid containing the contaminator, the third supply pipe 23 may be cleanly maintained.

### [Modified examples of a process chamber]

FIGS. 1D to 1J are cross-sectional views illustrating modified examples of the process chamber of FIG. 1B.

Referring to FIG. 1D, a pre-supercritical process zone 130 may have a downwardly inclined sidewall 132s toward the third supply pipe 23 and/or the exhaust pipe 26. Thus, the pre-supercritical process zone 130 may have a funnel-shape, such that it may be possible to smoothly and/or effectively exhaust the supercritical fluid and the condensed impurities.

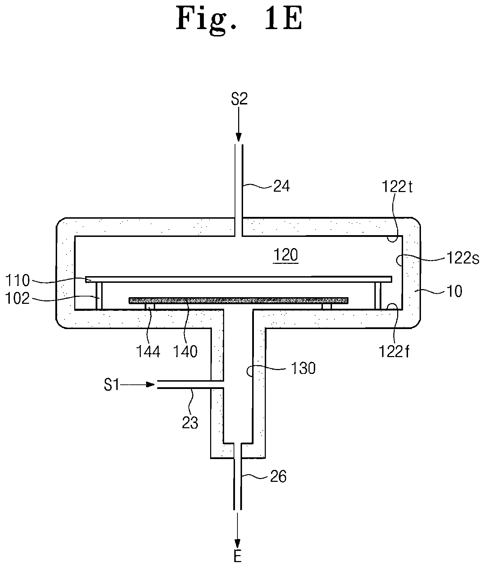

Referring to FIG. 1E, a pre-supercritical process zone 130 may be a narrow duct or passageway that is recessed from the bottom surface 122f of the supercritical process zone 120 and extends downward. The third supply pipe 23 may be connected to a sidewall of the pre-supercritical process zone 130, and the exhaust pipe 26 may be connected to a bottom surface of the pre-supercritical process zone 130. Thus, the condensed impurities may be smoothly and/or effectively exhausted. Moreover, the condensed impurities may be substantially prevented from being moved to the third supply pipe 23. In another embodiment, the pre-supercritical process zone 130 may extend upwardly from the top surface 122t or laterally from either one or both of the sidewall 122s of the supercritical process zone 120.

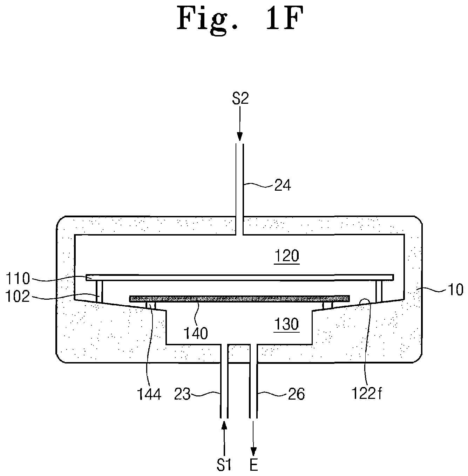

Referring to FIG. 1F, a bottom surface 122f of the supercritical process zone 120 may be inclined downward to the pre-supercritical process zone 130. Due to the downwardly inclined bottom surface 122f, it may be possible to smoothly and/or effectively supply the supercritical fluid to the supercritical process zone 120. The supercritical fluid may be smoothly and/or effectively exhaust to the pre-supercritical process zone 120 due to the inclined bottom surface 122f.

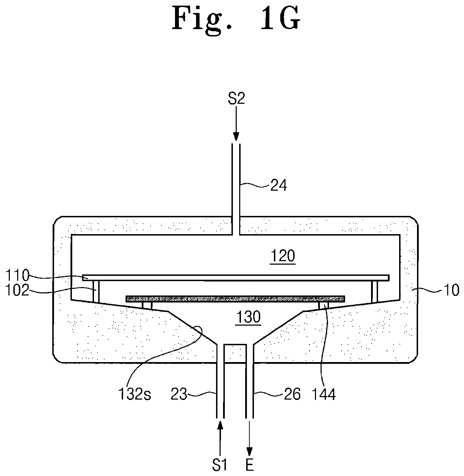

Referring to FIG. 1G, the supercritical process zone 120 may have the inclined bottom surface 122f downward to the pre-supercritical process zone 130, and the pre-supercritical process zone 120 may have the downwardly inclined sidewall 132s to the third supply pipe 23 and/or the exhaust pipe 26. A gradient of the bottom surface 122f of the supercritical process zone 120 may be substantially equal to or different from a gradient of the sidewall 132s of the pre-supercritical process zone 130. Thus, the supercritical process zone 120 and the pre-supercritical process zone 130 may have funnel-shapes, such that it may be possible to perform the smooth and/or effective supplying and exhausting of the supercritical fluid.

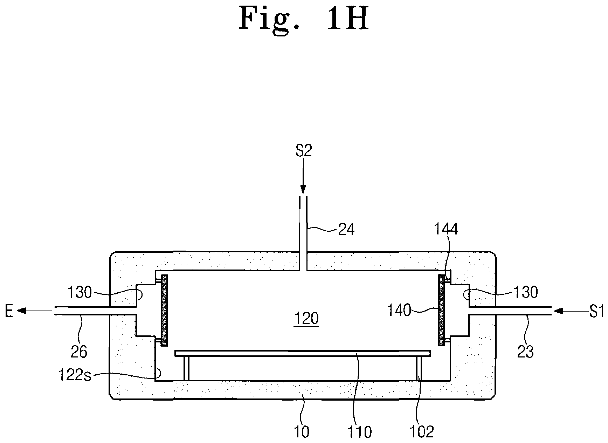

Referring to FIG. 1H, a pre-supercritical process zone 130 may have a ring-shape surrounding the sidewall 122s of the supercritical process zone 120. The third supply pipe 23 and the exhaust pipe 26 may face each other with the supercritical process zone 120 therebetween. For example, the third supply pipe 23 may be connected to a right sidewall of the supercritical process zone 120, and the exhaust pipe 26 may be connected to a left sidewall of the supercritical process zone 120. In another embodiment, the third supply pipe 23 and the exhaust pipe 26 may be connected to the right sidewall or left sidewall of the supercritical process zone 120 together.

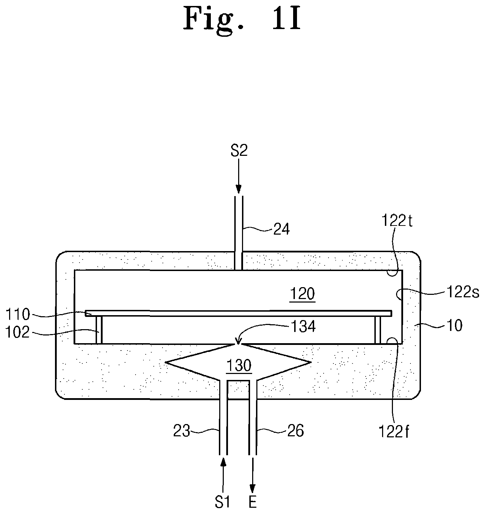

Referring to FIG. 1I, a pre-supercritical process zone 130 may have a diamond-shape formed under the bottom surface 122f of the supercritical process zone 120. The pre-supercritical process zone 130 may have a passage 134 opened toward the supercritical process zone 120. The passage 134 may function as the expansion nozzle. Thus, the substrate treatment system 1 according to the present modified example may not require the blocking plate 140 and the supporting parts 144 described in FIG. 1B. In another embodiment, the pre-supercritical process zone 130 according to the present modified example may be formed under the top surface 122t or the sidewall 122s of the supercritical process zone 120. The pre-supercritical process zone 130 may have one of various shapes such as a circular shape, a rhombus shape, an elliptic shape, and a polygonal shape except the diamond-shape.

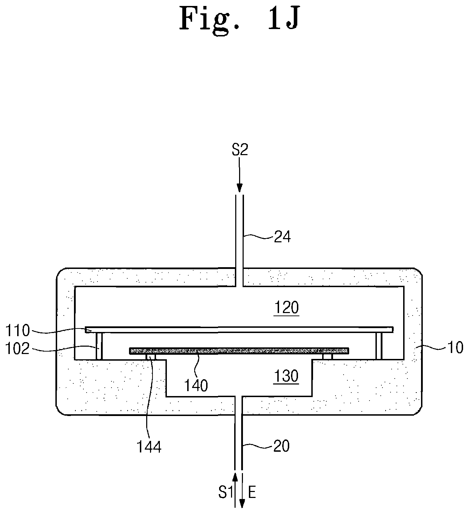

Referring to FIG. 1J, a process chamber 10 may include a single pipe 20 connected to the pre-supercritical process zone 130. The one pipe 20 may function as the third supply pipe 23 and the exhaust pipe 26 described above. For example, the single pipe 20 may be provided as a supply pipe of the supercritical fluid for creating the supercritical state, and be provided as an exhaust pipe of the supercritical fluid after the supercritical process.

### [Other embodiments of a substrate treatment system]

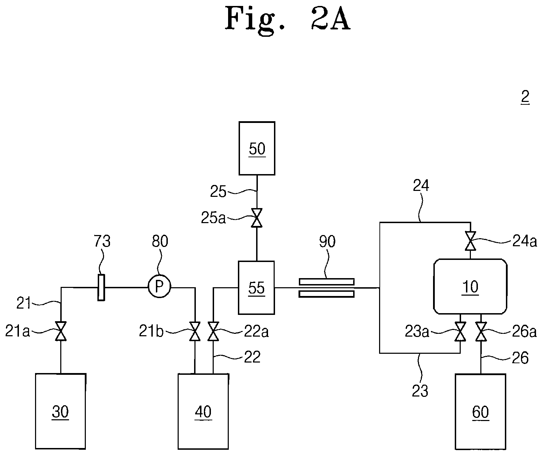

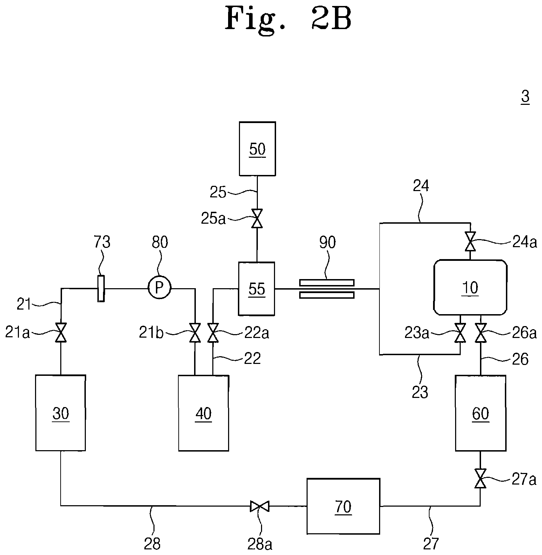

FIG. 2A is a schematic diagram illustrating a substrate treatment system according to another embodiment of the inventive concept. FIG. 2B is a schematic diagram illustrating a substrate treatment system according to still another embodiment of the inventive concept.

Referring to FIG. 2A, a substrate treatment system 2 according to the present embodiment may include the elements of the substrate treatment system 1 illustrated in FIG. 1A. Additionally, the substrate treatment system 2 may further include a storage tank 50 for storing a co-solvent and a mixing device 55 for mixing the supercritical fluid and the co-solvent. The co-solvent may include a cleaning fluid and/or an etching fluid mixed with the supercritical fluid. The mixing device 55 may be installed at the second supply pipe 22, and the storage tank 50 may provide the co-solvent into the mixing device 55 through a fifth supply pipe 25 at which a valve 25a is installed. In another embodiment, the mixing device 55 may be installed at the first supply pipe 21 or the fourth supply pipe 24. The substrate treatment system 2 may be provided with multiple storage tanks 50. One of the storage tanks 50 may store the cleaning fluid, and another of the storage tanks 50 may store the etching fluid. Thus, the substrate treatment system 2 may perform various supercritical processes such as a drying process, a cleaning process, and an etching process.

In an embodiment, if the co-solvent is a cleaning fluid, a supercritical cleaning fluid including the supercritical fluid (e.g., CO₂) and the cleaning fluid (e.g., IPA) may be supplied into the process chamber 10 to perform a supercritical cleaning process. For example, referring to FIGS. 1B and 2A, the supercritical fluid may be supplied into the pre-supercritical process zone 130 through the third supply pipe 23, so that the supercritical state may be created in the supercritical process zone 120. The supercritical cleaning fluid may be supplied into the supercritical process zone 120 of the supercritical state through the fourth supply pipe 24, thereby cleaning the substrate 110. The supercritical drying process described above may further be performed after the supercritical cleaning process.

In another embodiment, if the co-solvent is the etching fluid, a supercritical etching fluid including the supercritical fluid (e.g., CO₂) and the etching fluid (e.g., HF) may be supplied into the process chamber 10 to perform a supercritical etching process. For example, referring to FIGS. 1B and 2A, the supercritical fluid may be supplied into the pre-supercritical process zone 130 through the third supply pipe 23, so that the supercritical state may be created in the supercritical process zone 120. The supercritical etching fluid may be supplied into the supercritical process zone 120 of the supercritical state through the fourth supply pipe 24, thereby etching a structure formed on the substrate 110. The supercritical drying process and/or the supercritical cleaning process described above may further be performed after the supercritical etching process.

Referring to FIG. 2B, a substrate treatment system 3 according to the present embodiment may include the elements of the substrate treatment system 2 illustrated in FIG. 2A. Additionally, the substrate treatment system 3 may further include a regenerating device 70. The regenerating device 70 may be connected to a recovery pipe 28 at which a valve 27a is installed. The regenerating device 70 may be provided with a supercritical fluid from a recovery device 60 and provide a regenerated fluid of a liquid state to the supplying device 30 through a regeneration pipe 28 at which a value 28a is installed. For example, the regenerating device 70 may make the supercritical fluid into a fluid of a gas state and then separate contaminants from the fluid of the gas state. Additionally, the regenerating device 70 may condense the fluid of the gas state to form the fluid of the liquid state.

### [Comparative Example]

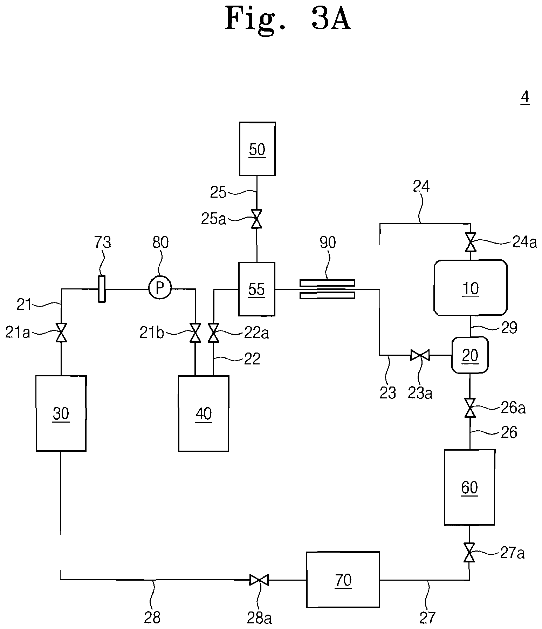

FIG. 3A is a schematic diagram illustrating a substrate treatment system according to concept comparative example.

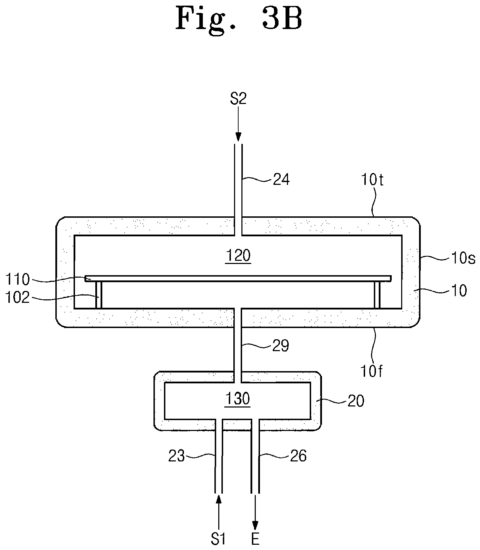

FIG. 3B is a cross-sectional view illustrating a process chamber and an expansion chamber in a substrate treatment system according to the comparative example.

Referring to FIG. 3A, a substrate treatment system 4 may include a process chamber 10 in which the supercritical process is performed, an expansion chamber 20 in which the supercritical fluid is pre-expanded, and a middle pipe 29 installed between the process chamber 10 and the expansion chamber 20. The supercritical fluid pre-expanded in the expansion chamber 20 may be supplied into the process chamber 10 through the middle pipe 29. The exhaust pipe 26 may be installed between the expansion chamber 20 and the recovery tank 60. Other elements of the substrate treatment system 4 may be the same as or similar to the elements corresponding thereto in one of the substrate treatment systems 1 to 3 described above.

Referring to FIG. 3B, the process chamber 10 may include the supercritical process zone 120, and the expansion chamber 20 may include the pre-supercritical process zone 130. The expansion chamber 20 may be spaced apart from a bottom wall 10f of the process chamber 10. Alternatively, the expansion chamber 20 may be spaced apart from a top wall 10t or a sidewall 10s of the process chamber 10.

The third supply pipe 23 may be connected to the expansion chamber 20 to supply a supercritical fluid into the pre-supercritical process zone 130 (S1), and the fourth supply pipe 24 may be connected to the process chamber 10 to supply a supercritical fluid into the supercritical process zone 120 (S2). The middle pipe 29 may supply the supercritical fluid pre-expanded in the pre-supercritical process zone 130 into the supercritical process zone 120. Thus, the supercritical process zone 120 may be in the supercritical state.

After the supercritical process, the supercritical fluid containing the contaminants may be moved into the expansion chamber 20 from the process chamber 10 through the middle pipe 29 and then be exhausted from the expansion chamber 20 through the exhaust pipe 26 along with condensed impurities in the pre-supercritical process zone 130 (E).

According to the comparative example, because the pre-supercritical process zone 130 is separated from the process chamber 10, it may be possible to substantially reduce the movement of the condensed impurities, which are generated by the expansion of the supercritical fluid, from the pre-supercritical process zone 130 to the supercritical process zone 120. Thus, a degree of cleanness of the supercritical process zone 120 may be enhanced.

### [Yet another embodiment of a substrate treatment system]

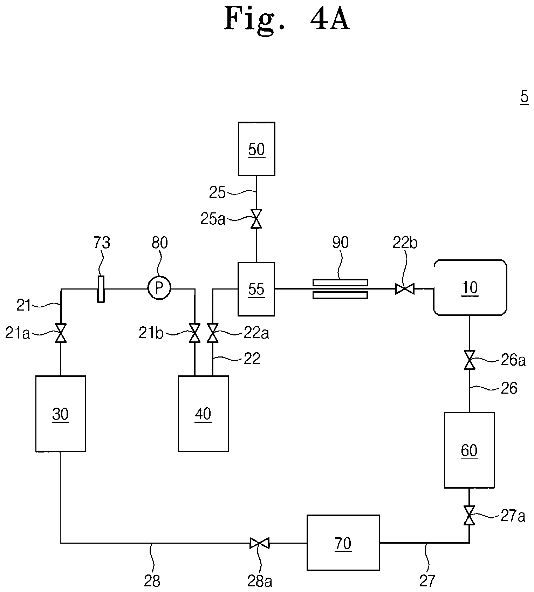

FIG. 4A is a schematic diagram illustrating a substrate treatment system according to yet another embodiment of the inventive concept.

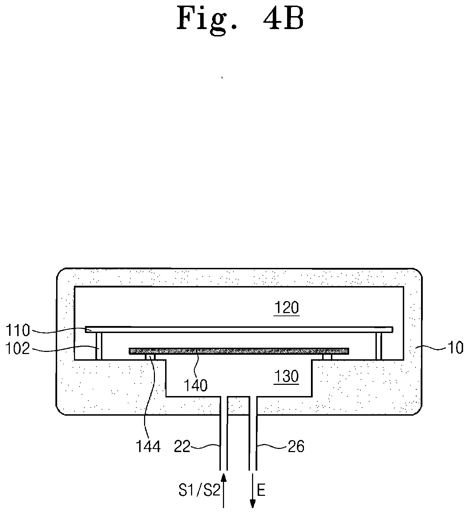

FIG. 4B is a cross-sectional view illustrating a process chamber and an expansion chamber in a substrate treatment system according to yet another embodiment of the inventive concept.

Referring to FIGS. 4A and 4B, a substrate treatment system 5 may include a second supply pipe 22 connected to the pre-supercritical process zone 130 of the process chamber 10. Valves 22a and 22b are installed at the second supply pipe 22. A flow of the supercritical fluid in the second supply pipe 22 may be controlled by the valve 22b adjacent to the process chamber 10. According to the present embodiment, the supercritical fluid may be supplied once to perform the supercritical process, or the supercritical fluid may be supplied twice to perform the supercritical process.

For example, the supercritical fluid may be supplied into the pre-supercritical process zone 130 through the second supply pipe 22 (S1), and then the supercritical fluid filtered in the pre-supercritical process zone 130 may be supplied into the supercritical process zone 120 to make the supercritical state in the supercritical process zone 120. In this case, the supercritical process may be performed without the second supply of the supercritical fluid. In other words, the supercritical process may be performed with only the first supply of the supercritical fluid. Also, the first and second supplies of the supercritical fluid can be done in a single supply pipe.

Alternatively, the supercritical fluid may be supplied (first supply) to make the supercritical state in the supercritical process zone 120 (S1), and the supercritical fluid may be additionally supplied (second supply) into the pre-supercritical process zone 130 to perform the supercritical process (S2).

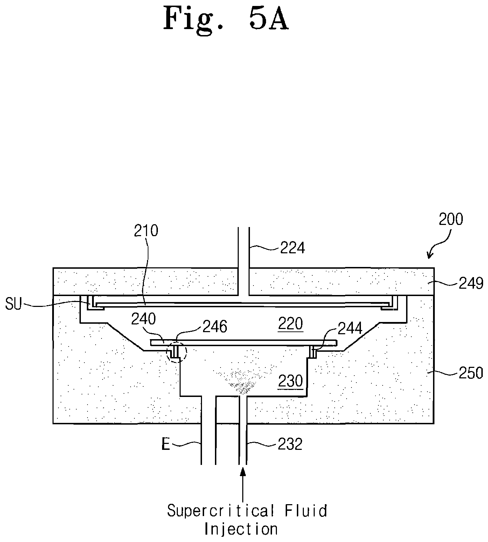

In some embodiments, as shown in FIG. 5A, a substrate treatment system may include an apparatus or process chamber 200 for performing a supercritical process described above. The apparatus or process chamber 200 can include a pre-supercritical process zone 230 configured to receive a supercritical fluid therein and a supercritical process zone 220 in fluid communication with the pre-supercritical process zone 230. As in the previous embodiments, the supercritical process zone 220 is configured to enable treating a substrate or wafer 210 therein using the supercritical fluid. The pre-supercritical process zone 230 may be arranged and structured to permit expansion of the supercritical fluid before the supercritical fluid reaches the supercritical process zone 220, and the pre-supercritical process zone 230 and the supercritical process zones 220 divided (e.g., physically) from each other.

In one embodiment, the pre-supercritical process zone 230 and the supercritical process zones 220 may be divided from each other with one or more passages configured therebetween to provide fluid communication between the pre-supercritical process zone 230 and the supercritical process zone 220. The passages may be passages 145 shown in FIG. 1C.

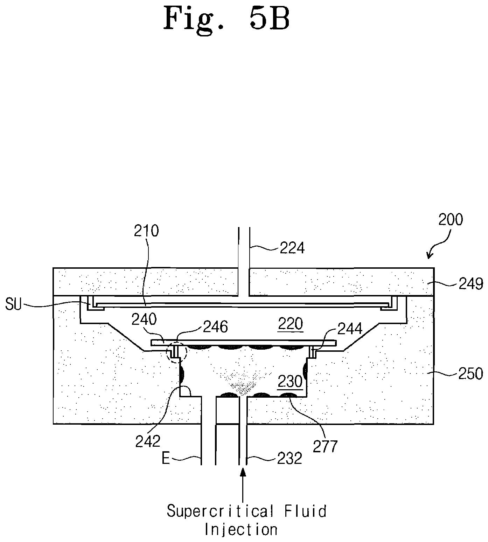

As shown in FIG. 5B, impurities or particles 277 contained in the supercritical fluid are condensed or deposited during the expansion such that a substantial portion of the impurities 277 are confined or restricted within the pre-supercritical process zone 230. More particularly, a substantial portion of the impurities in the supercritical fluid may adhere to a wall defining the pre-supercritical process zone 230.

In one embodiment, a bottom portion 250 of the process chamber 200 is recessed to define the pre-supercritical process zone 230. The pre-supercritical process zone 230 and the supercritical process zone 220 are physically divided from each other by a blocking plate 240. The blocking plate 240 may have a circular shape in plan view similar to the blocking plate shown in FIG. 1C.

In some embodiments, the process chamber 200 has supporting parts 244 disposed along a circumferential edge of the blocking plate 240 to support the blocking plate 240 a predetermined distance above a bottom surface 242 of the pre-supercritical process zone 230 similar to the embodiments discussed above, e.g., FIG. 1C. The supporting parts 244 are spaced apart from each other. The supporting parts 244 may each be a post or pillar.

In one embodiment, as shown in FIGS. 5A-5C, a step region 246 may be defined between the pre-supercritical process zone 230 and the supercritical process zone 220. The supporting parts 244 may be disposed within the step region 246 such that the supporting parts 244 can be stably affixed to the process chamber 200.

Although in the previous embodiments, the substrate has been described as being supported by supporting pins or lift pins; in some alternative embodiments, a substrate 210 may be supported by a supporting unit SU extending downwardly from a top portion 249 of the process chamber 20.

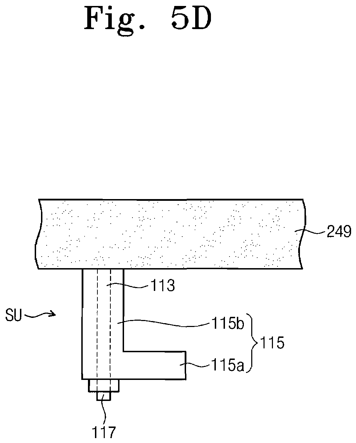

FIG. 5D illustrates a magnified cross-sectional view of a supporting unit SU according to one embodiment. Referring to FIG. 5D, the supporting unit SU may have a support member 115 and a support pin 113. The support member 115 can have an extension member 115b and an arm or ledge member 115a that extends therefrom to support the substrate 210. The support pin 113 can extend through the extension member 115b of the support member 115 to affix the support member 115 to the top portion 249 of the process chamber 200. The support pin 113 can, for instance, include a bolt that extends through the support member 115 into the top portion 249 of the process chamber 200. The support pin 113 may be welded to the top portion 249 of the process chamber 200. A nut 117 can be threaded onto an end of the bolt below the support member 115 to secure the support member 115 in place. The support member 115 of the supporting unit SU can be replaced after a certain period of use without replacing the whole supporting unit SU. The equipment can therefore be easily and efficiently maintained.

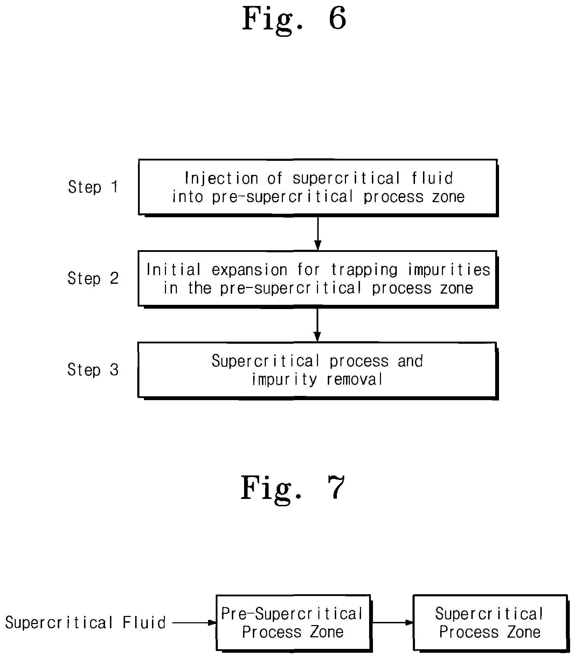

FIG. 6 illustrates a method of treating a substrate using a supercritical fluid according to some embodiments discussed above. The method can include providing or injecting a supercritical fluid into a pre-supercritical process zone in a manner (Step 1) as shown in FIG. 5A. The supercritical fluid is expanded to condense or deposit impurities 277 in the pre-supercritical process zone 230. This expansion may be substantially confined or restricted to occurring within the pre-supercritical process zone 230, as illustrated for example in FIG. 5B.

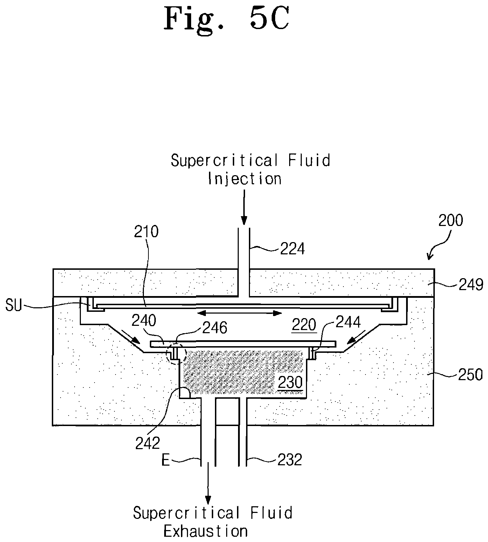

The supercritical fluid may be injected or provided through a first supply pipe (see, for example, 232 of FIG. 5A) into the pre-supercritical process zone 230, thereby creating a supercritical state in the supercritical process zone 220. The supercritical fluid may then be supplied through the first supply pipe or a second supply pipe (see, e.g., element 224 of FIG. 5C) into the supercritical process zone 220 of the process chamber in the supercritical state. As a result, a substantial portion of the impurities contained in the supercritical fluid can be removed from the supercritical fluid in the pre-supercritical process zone 230 before the supercritical fluid reaches the supercritical process zone 220. This can thereby significantly reduce impurities or particles which might otherwise be undesirably adhered to the substrate 210.

More particularly, impurities contained in the supercritical fluid may be condensed or deposited during the initial expansion of the supercritical fluid, such that they adhere to a wall defining the pre-supercritical process zone (see FIG. 5B). Thus, a substantial portion of the impurities can be trapped in the pre-supercritical process zone.

The substrate 210 in the supercritical process zone 220 may then be treated using the supercritical fluid (Step 3) (see FIG. 5C). More particularly, the supercritical fluid provided or injected into the supercritical process zone 220 in the supercritical state treats (e.g., through a drying or cleaning process) the substrate 210. Also, any impurities condensed in the supercritical process zone due to the expansion of the supercritical fluid therein are dissolved by the used supercritical fluid and exhausted through an exhaust pipe E (see, e.g., FIG. 5C).

In another embodiment, a method of treating a substrate in a treatment apparatus having a pre-supercritical process zone and a supercritical process zone, can include: providing a first supply of a supercritical fluid into the pre-supercritical process zone to trap impurities in the pre-supercritical process zone by permitting expansion of the supercritical fluid before the supercritical fluid reaches the supercritical process zone; generating a supercritical state in the supercritical process zone by supplying the expanded supercritical fluid from the pre-supercritical process zone to the supercritical process zone; and treating a substrate in the supercritical process zone using the supercritical fluid.

In summary, as illustrated in FIG. 7, by injecting a supercritical fluid into a pre-supercritical process zone and permitting expansion of the supercritical fluid confined in the pre-supercritical process zone before the supercritical fluid reaches a supercritical process zone or chamber, a substantial portion of impurities or particles can be effectively trapped in the pre-supercritical process zone and removed from the supercritical fluid. As a result, even if the supercritical fluid is expanded again (second expansion) in the supercritical process zone, the condensation problem discussed above can be substantially reduced. Such inventive concepts can be practiced without necessarily being limited to embodiments discussed above. For example, process chambers having different types or shapes than described above can be used within the spirit and scope of the present disclosure.

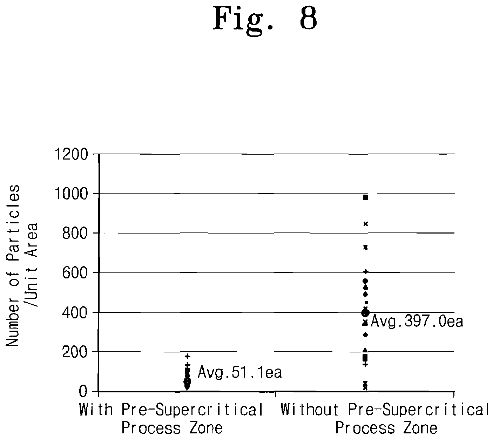

With such novel inventive concepts, the applicant of the present application has found that a number of particles or impurities occurring on a unit area of a semiconductor wafer during a supercritical process has been significantly reduced as shown in FIG. 8.

Throughout the specification, features shown in one embodiment may be incorporated in other embodiments within the spirit and scope of the inventive concept.

Reference throughout this specification to "one embodiment" or "an embodiment" means that a particular feature, structure, or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

Spatially relative terms, such as "beneath", "below", "lower", "above", "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

Various operations may be described as multiple discrete steps performed in a manner that is most helpful in understanding the invention. However, the order in which the steps are described does not imply that the operations are order-dependent or that the order that steps are performed must be the order in which the steps are presented.

With respect to the use of substantially any plural and/or singular terms herein, those having skill in the art can translate from the plural to the singular or from the singular to the plural as is appropriate to the context and/or application. The various singular/plural permutations may be expressly set forth herein for sake of clarity.

According to some embodiments of the inventive concept, the supercritical state is created in the chamber before the supercritical process is performed. Thus, the properties of the supercritical fluid may be maintained during the supercritical process, so that the substrate treating ability may be improved. Additionally, it is possible to prevent the substrate from being contaminated and to prevent the treating ability of the supercritical fluid from being deteriorated. The structure of the chamber may be changed for gathering particles caused from the supercritical fluid, so that particle management ability and substrate treating yield may be improved. Additionally, the condensed impurities may be exhausted along the supercritical fluid, so that the cleaned degree of the chamber may be improved. As a result, it is possible to prevent the substrate from being contaminated and to easily manage maintenance of the substrate treatment system.

While the inventive concept has been described with reference to example embodiments, it will be apparent to those skilled in the art that various changes and modifications may be made without departing from the scope of the claims. Therefore, it should be understood that the above embodiments are not limiting, but illustrative. Thus, the scope of the inventive concept is to be determined by the broadest permissible interpretation of the following claims and their equivalents, and shall not be restricted or limited by the foregoing description.

## Claims

1. An apparatus for treating a substrate, the apparatus including:
a pre-supercritical process zone (130; 230) for receiving a supercritical fluid therein; and
a supercritical process zone (120; 220) in fluid communication with the pre-supercritical process zone (130; 230), the supercritical process zone (120; 220) being configured to enable treating a substrate (110; 210) therein using the supercritical fluid,
wherein the pre-supercritical process zone (130; 230) is arranged and structured to permit expansion of the supercritical fluid before the supercritical fluid reaches the supercritical process zone (120; 220), and
wherein the pre-supercritical process zone (130; 230) and the supercritical process zones (120; 220) are divided from each other,
**characterized in that** the pre-supercritical process zone (130; 230) and the supercritical process zone (120; 220) are physically divided from each other by a blocking plate (140; 240), and
the apparatus further comprises supporting parts (144; 244) disposed along a circumferential edge of the blocking plate (140; 240) to support the blocking plate (140; 240) at a predetermined distance above a bottom surface (242) of the pre-supercritical process zone (130; 230), the supporting parts (144; 244) being spaced apart from each other.

2. The apparatus of claim 1, wherein the apparatus includes a process chamber (10; 200), wherein a bottom portion (250) of the process chamber (10; 200) is recessed to define the pre-supercritical process zone (130; 230).

3. The apparatus of claim 1, wherein the blocking plate (140; 240) has a circular shape in plan view.

4. The apparatus of claim 1, wherein a step region (246) is defined between the pre-supercritical process zone (230) and the supercritical process zone (220), and wherein the supporting parts (244) are disposed within the step region (246).

5. The apparatus of claim 1 or 4, wherein one or more passages (145) are defined by the blocking plate (140), a surface of the pre-supercritical process zone (130), and the supporting parts (144).

6. The apparatus of any one of clams 1 to 5, wherein the blocking plate (140; 240) covers the pre-supercritical process zone (130; 230).

7. The apparatus of any one of claims 1 to 6, wherein the pre-supercritical process zone (130; 230) has a smaller volume than the supercritical process zone (120; 220), wherein the volume of the pre-supercritical process zone (130; 230) is preferably in a range of about 0.1% to about 20% of the volume of the supercritical process zone (120; 220).

8. The apparatus of claim 6, wherein the pre-supercritical process zone (130) has a ring-shape surrounding a sidewall (122s) of the supercritical process zone (120).

9. A system configured to treat a substrate, the system comprising:
the apparatus for treating a substrate according to any one of claims 1 to 8, wherein:
the pre-supercritical process zone (130; 230) is configured to receive a first supply (S1) of a supercritical fluid thereto,
the supercritical process zone (120; 220) is configured to receive a second supply (S2) of the supercritical fluid thereto, and
wherein the pre-supercritical process zone (130; 230) and the supercritical process zone (120; 220) are divided from each other with one or more passages (145) configured therebetween to provide fluid communication between the pre-supercritical process zone (130; 230) and the supercritical process zone (120; 220); and
a supplying device (30) configured to provide the first and second supplies of the supercritical fluid to the apparatus for treating a substrate.

10. The system of claim 9, wherein the supplying device (30) is configured to provide the first supply (S1) of the supercritical fluid before providing the second supply (S2) of the supercritical fluid.

11. The system of claim 9 or 10, further comprising a condenser (73) and a pump (80), the condenser (73) being upstream of the pump (80), wherein the supercritical fluid passes through the condenser (73) and the pump (80).

12. The system of any one of claims 9 to 11, wherein the first supply (S1) of the supercritical fluid generates a supercritical state in the supercritical process zone (120; 220) and wherein the supplying device (30) is configured to provide the second supercritical fluid supply (S2) to the supercritical process zone (120; 220) in the state in that the supercritical process zone (120; 220) is in the supercritical state.

13. The system of any one of claims 9 to 12, wherein the first supply of supercritical fluid is provided through a first supply pipe (23; 10; 223), which is in fluid communication with the pre-supercritical process zone, and the second supply of supercritical fluid is provided through a second supply pipe (24; 232), which is in communication with the supercritical process zone.

14. The system of claim 13, wherein one of the first and second supply pipes (20) further acts as an exhaust pipe to exhaust impurities or particles from the apparatus for treating a substrate.

15. The system of claim 13, further comprising an exhaust pipe (26; E) in communication with the pre-supercritical process zone (130; 230).

16. The system of claim 9, wherein the supplying device (30) is configured to sequentially provide the first and second supplies (S1, S2) of the supercritical fluid to the apparatus for treating a substrate.

17. The system of any one of claims 9 to 16, wherein:
the supercritical process zone (120) includes a top surface (122t) and a bottom surface (122f) facing each other; and a sidewall (122s) connected between the top surface (122t) and the bottom surface (122f), and
wherein a portion of one or more of the top surface (122t), the bottom surface (122f), and the sidewall (122s) of the supercritical process zone (120) are recessed to define the pre-supercritical process zone (130).

18. The system of any one of claims 9 to 16, wherein:
the supercritical process zone (120) includes a top surface (122t) and a bottom surface (122f) facing each other; and a sidewall (122s) connected between the top surface (122t) and the bottom surface (122f), and
wherein the bottom surface (122f) of the supercritical process zone (120) is inclined downward to form the pre-supercritical process zone (130).

19. The system of any one of claims 9 to 16, wherein:
the supercritical process zone (120) includes a top surface (122t) and a bottom surface (122f) facing each other; and a sidewall (122s) connected between the top surface (122t) and the bottom surface (122f), and
wherein the pre-supercritical process zone (130) includes a sidewall extending upward from the bottom surface.

20. The system of claim 19, wherein the upwardly extending sidewall of the pre-supercritical process zone is inclined to form the supercritical process zone.

21. The system of claim 9, wherein a portion of a bottom surface (122f) of the supercritical process zone (120) is recessed to define the pre-supercritical process (130) zone; a width of the pre-supercritical process zone (130) is progressively reduced toward the supercritical process zone (120); and the pre-supercritical process zone (130) includes a passage (134) opened toward the supercritical process zone (120).

22. The system of claim 9, further comprising at least one of the following:
a buffer tank (40) provided between the supplying device (30) and the apparatus for treating a substrate; a co-solvent storage tank (50) provided between the supplying device (30) and the apparatus for treating a substrate; a co-solvent supplying device (25a, 55) including a mixer (55) mixing a co-solvent and the supercritical fluid; a recovery tank (60) configured to store a supercritical fluid exhausted from the apparatus for treating a substrate; and a regeneration device (70) configured to regenerate a supercritical fluid containing a contaminator which is exhausted from the apparatus for treating a substrate into a liquid fluid from which impurities are removed.

23. The system of any one of claims 9 to 21, wherein the apparatus treating device includes a process chamber having the supercritical process zone therein; and the pre-supercritical process zone occupies a portion of an internal region of the process chamber.

24. The system of claim 23, further comprising: a main supply pipe (21, 22) connected to the supplying device (30) to supply the supercritical fluid to the process chamber (10); and a first supply pipe (23) and a second supply pipe (24) diverging from the main supply pipe (20, 22) and connected to the process chamber (10).

## Patentansprüche

1. Vorrichtung zum Behandeln eines Substrats, wobei die Vorrichtung beinhaltet:
eine prä-überkritische Prozesszone (130; 230), um darin ein überkritisches Fluid aufzunehmen; und
eine überkritische Prozesszone (120; 220) in Fluidkommunikation mit der prä-überkritischen Prozesszone (130; 230), wobei die überkritische Prozesszone (120; 220) so konfiguriert ist, dass sie ein Behandeln eines Substrats (110; 210) darin unter Verwendung des superkritischen Fluids ermöglicht,
wobei die prä-überkritische Prozesszone (130; 230) so angeordnet und strukturiert ist, dass sie eine Ausdehnung des überkritischen Fluids ermöglicht, bevor das überkritische Fluid die überkritische Prozesszone (120; 220) erreicht, und
wobei die prä-überkritische Prozesszone (130; 230) und die überkritischen Prozesszonen (120; 220) voneinander getrennt sind,
**dadurch gekennzeichnet, dass** die prä-überkritische Prozesszone (130; 230) und die überkritische Prozesszone (120; 220) durch eine Blockierplatte (140; 240) physisch voneinander getrennt sind, und
die Vorrichtung ferner Trageteile (144; 244) aufweist, die entlang einer Umlaufkante der Blockierplatte (140; 240) angeordnet sind, um die Blockierplatte (140; 240) in einer vorgegebenen Entfernung über einer Bodenoberfläche (242) der prä-überkritischen Prozesszone (130; 230) zu tragen, wobei die Trageteile (144; 244) voneinander beabstandet sind.

2. Vorrichtung nach Anspruch 1, wobei die Vorrichtung eine Prozesskammer (10; 200) enthält, wobei ein Bodenabschnitt (250) der Prozesskammer (10; 200) vertieft ist, um die prä-überkritische Prozesszone (130; 230) zu definieren.

3. Vorrichtung nach Anspruch 1, wobei die Blockierplatte (140; 240) in einer planaren Ansicht eine kreisrunde Form aufweist.

4. Vorrichtung nach Anspruch 1, wobei ein Stufenbereich (246) zwischen der prä-überkritischen Prozesszone (230) und der überkritischen Prozesszone (220) definiert ist, und wobei sich die Trageteile (244) innerhalb des Stufenbereichs (246) befinden.

5. Vorrichtung nach Anspruch 1 oder 4, wobei eine oder mehrere Leitungen (145) durch die Blockierplatte (140), eine Oberfläche der prä-überkritischen Prozesszone (130) und die Trageteile (144) definiert sind.

6. Vorrichtung nach einem der Ansprüche 1 bis 5, wobei die Blockierplatte (140; 240) die prä-überkritische Prozesszone (130; 230) bedeckt.

7. Vorrichtung nach einem der Ansprüche 1 bis 6, wobei die prä-überkritische Prozesszone (130; 230) ein geringeres Volumen aufweist als die überkritische Prozesszone (120; 220), wobei das Volumen der prä-überkritischen Prozesszone (130; 230) vorzugsweise in einem Bereich zwischen circa 0,1% und 20% des Volumens der überkritischen Prozesszone (120; 220) liegt.

8. Vorrichtung nach Anspruch 6, wobei die prä-überkritische Prozesszone (130) eine Ringform aufweist, die eine Seitenwand (122s) der überkritischen Prozesszone (120) umgibt.

9. System, das konfiguriert ist, ein Substrat zu behandeln, wobei das System aufweist:
die Vorrichtung zum Behandeln eines Substrats nach einem der Ansprüche 1 bis 8, wobei:
die prä-überkritische Prozesszone (130; 230) so konfiguriert ist, dass sie eine erste Zufuhr (S1) eines überkritischen Fluids empfängt,
die überkritische Prozesszone (120; 220) so konfiguriert ist, dass sie eine zweite Zufuhr (S2) des überkritischen Fluids empfängt, und
wobei die prä-überkritische Prozesszone (130; 230) und die überkritische Prozesszone (120; 220) voneinander getrennt sind, wobei eine oder mehrere Leitungen (145) dazwischen so konfiguriert sind, dass sie eine Fluidkommunikation zwischen der prä-überkritischen Prozesszone (130; 230) und der überkritischen Prozesszone (120; 220) bereitstellen; und
wobei eine Zuführvorrichtung (30) so konfiguriert ist, dass sie der Vorrichtung zum Behandeln eines Substrats die erste und zweite Zufuhr des überkritischen Fluids bereitstellt.

10. System nach Anspruch 9, wobei die Zuführvorrichtung (30) so konfiguriert ist, dass sie die erste Zufuhr (S1) des überkritischen Fluids bereitstellt, bevor sie die zweite Zufuhr (S2) des überkritischen Fluids bereitstellt.

11. System nach Anspruch 9 oder 10, ferner aufweisend einen Kondensor (73) und eine Pumpe (80), wobei der Kondensor (73) stromaufwärts von der Pumpe (80) angeordnet ist, wobei das überkritische Fluid durch den Kondensor (73) und die Pumpe (80) strömt.

12. System nach einem der Ansprüche 9 bis 11, wobei die erste Zufuhr (S1) des überkritischen Fluids einen überkritischen Zustand in der überkritischen Prozesszone (120; 220) erzeugt, und wobei die Zuführvorrichtung (30) so konfiguriert ist, dass sie der überkritischen Prozesszone (120; 220) in dem Zustand, bei dem sich die überkritische Prozesszone (120; 220) in dem überkritischen Zustand befindet, die zweite überkritische Fluidzufuhr (S2) bereitstellt.

13. System nach einem der Ansprüche 9 bis 12, wobei die erste Zufuhr des überkritischen Fluids durch eine erste Zuführleitung (23; 10; 223) erfolgt, die sich mit der prä-überkritischen Prozesszone in Fluidkommunikation befindet, und die zweite Zufuhr des überkritischen Fluids durch eine zweite Zuführleitung (24; 232) erfolgt, die mit der überkritischen Prozesszone kommuniziert.

14. System nach Anspruch 13, wobei eines von der ersten und der zweiten Zuführleitung (20) ferner als eine Auslassleitung fungiert, um Unreinheiten oder Partikel aus der Vörrichtung zum Behandeln eines Substrats auszustoßen.

15. System nach Anspruch 13, ferner aufweisend eine Auslassleitung (26; E), die mit der prä-überkritischen Prozesszone (130; 230) kommuniziert.

16. System nach Anspruch 9, wobei die Zuführvorrichtung (30) so konfiguriert ist, dass sie die erste und zweite Zufuhr (S1, S2) des überkritischen Fluids der Vorrichtung zum Behandeln eines Substrats sequentiell bereitstellt.

17. System nach einem der Ansprüche 9 bis 16, wobei:
die überkritische Prozesszone (120) eine obere Oberfläche (122t) und eine untere Oberfläche (122f), die einander zugewandt sind, und eine Seitenwand (122s), die zwischen der oberen Oberfläche (122t) und der unteren Oberfläche (122f) verbunden ist, beinhaltet, und
wobei ein Abschnitt von einem oder mehreren von der oberen Oberfläche (122t), der unteren Oberfläche (122f) und der Seitenwand (122s) der überkritischen Prozesszone (120) vertieft ist, um die prä-überkritische Prozesszone (130) zu definieren.

18. System nach einem der Ansprüche 9 bis 16, wobei:
die überkritische Prozesszone (120) eine obere Oberfläche (122t) und eine untere Oberfläche (122f), die einander zugewandt sind, und eine Seitenwand (122s), die zwischen der oberen Oberfläche (122t) und der unteren Oberfläche (122f) verbunden ist, beinhaltet, und
wobei die untere Oberfläche (122f) der überkritischen Prozesszone (120) nach unten geneigt ist, um die prä-überkritische Prozesszone (130) zu bilden.

19. System nach einem der Ansprüche 9 bis 16, wobei:
die überkritische Prozesszone (120) eine obere Oberfläche (122t) und eine untere Oberfläche (122f), die einander zugewandt sind, und eine Seitenwand (122s), die zwischen der oberen Oberfläche (122t) und der unteren Oberfläche (122f) verbunden ist, beinhaltet, und
wobei die prä-überkritische Prozesszone (130) eine Seitenwand beinhaltet, die von der unteren Oberfläche aus nach oben verläuft.

20. System nach Anspruch 19, wobei die nach oben verlaufende Seitenwand der prä-überkritischen Prozesszone geneigt ist, um die überkritische Prozesszone zu bilden.

21. System nach Anspruch 9, wobei ein Abschnitt einer unteren Oberfläche (122f) der überkritischen Prozesszone (120) vertieft ist, um die prä-überkritische Prozesszone (130) zu definieren; eine Breite der prä-überkritischen Prozesszone (130) progressiv in Richtung der überkritischen Prozesszone (120) reduziert ist; und die prä-überkritische Prozesszone (130) eine Leitung (134) beinhaltet, die in Richtung der überkritischen Prozesszone (120) geöffnet ist.

22. System nach Anspruch 9, ferner aufweisend zumindest eines der Folgenden:
einen Puffertank (40), der sich zwischen der Zuführvorrichtung (30) und der Vorrichtung zum Behandeln eines Substrats befindet; einen Zusatzlösungsmittel-Speichertank (50), der sich zwischen der Zuführvorrichtung (30) und der Vorrichtung zum Behandeln eines Substrats befindet; eine Zusatzlösungsmittel-Zuführvorrichtung (25a, 55), die einen Mischer (55) enthält, der ein Zusatzlösungsmittel und das überkritische Fluid mischt; einen Rückgewinnungstank (60), der so konfiguriert ist, dass er ein überkritisches Fluid speichert, das von der Vorrichtung zum Behandeln eines Substrats ausgestoßen wurde; und eine Regenerationsvorrichtung (70), die so konfiguriert ist, dass sie ein überkritisches Fluid, das einen Kontaminator enthält und aus der Vorrichtung zum Behandeln eines Substrats ausgestoßen wird, in ein liquides Fluid regeneriert, aus dem Unreinheiten entfernt sind.

23. System nach einem der Ansprüche 9 bis 21, wobei die Vorrichtung zum Behandeln einer Vorrichtung eine Prozesskammer beinhaltet, in der sich die überkritische Prozesszone befindet; und wobei die prä-überkritische Prozesszone einen Abschnitt eines Innenbereichs der Prozesskammer einnimmt.

24. System nach Anspruch 23, ferner aufweisend: eine Hauptzuführleitung (21, 22), die mit der Zuführvorrichtung (30) verbunden ist, um das überkritische Fluid der Prozesskammer (10) zuzuführen; und eine erste Zuführleitung (23) und eine zweite Zuführleitung (24), die aus der Hauptzuführleitung (20, 22) abgezweigt und mit der Prozesskammer (10) verbunden sind.

## Revendications

1. Appareil de traitement d'un substrat, l'appareil comprenant :
une zone de procédé pré-supercritique (130 ; 230) pour recevoir un fluide supercritique dans celle-ci ; et
une zone de procédé supercritique (120 ; 220) en communication fluidique avec la zone de procédé pré-supercritique (130 ; 230), la zone de procédé supercritique (120 ; 220) étant configurée pour permettre de traiter un substrat (110 ; 210) dans celle-ci en utilisant le fluide supercritique,
dans lequel la zone de procédé pré-supercritique (130 ; 230) est agencée et structurée pour permettre l'expansion du fluide supercritique avant que le fluide supercritique n'atteigne la zone de procédé supercritique (120 ; 220), et
dans lequel la zone de procédé pré-supercritique (130 ; 230) et la zone de procédé supercritique (120 ; 220) sont séparées l'une de l'autre,
**caractérisé en ce que** la zone de procédé pré-supercritique (130 ; 230) et la zone de procédé supercritique (120 ; 220) sont physiquement séparées l'une de l'autre par une plaque de blocage (140 ; 240), et
l'appareil comprend en outre des pièces de support (144 ; 244) disposées le long d'un bord circonférentiel de la plaque de blocage (140 ; 240) pour supporter la plaque de blocage (140 ; 240) à une distance prédéterminée au-dessus d'une surface inférieure (242) de la zone de procédé pré-supercritique (130 ; 230), les pièces de support (144 ; 244) étant espacées les unes des autres.

2. Appareil selon la revendication 1, dans lequel l'appareil comprend une chambre de procédé (10 ; 200), dans lequel une portion inférieure (250) de la chambre de procédé (10 ; 200) est en retrait pour définir la zone de procédé pré-supercritique (130 ; 230).

3. Appareil selon la revendication 1, dans lequel la plaque de blocage (140 ; 240) a une forme circulaire en vue en plan.

4. Appareil selon la revendication 1, dans lequel une région palier (246) est définie entre la zone de procédé pré-supercritique (230) et la zone de procédé supercritique (220), et dans lequel les pièces de support (244) sont disposées dans la région palier (246).

5. Appareil selon la revendication 1 ou 4, dans lequel un ou plusieurs passages (145) sont définis par la plaque de blocage (140), une surface de la zone de procédé pré-supercritique (130), et les pièces de support (144).

6. Appareil selon l'une quelconque des revendications 1 à 5, dans lequel la plaque de blocage (140 ; 240) couvre la zone de procédé pré-supercritique (130 ; 230).

7. Appareil selon l'une quelconque des revendications 1 à 6, dans lequel la zone de procédé pré-supercritique (130 ; 230) a un volume inférieur à celui de la zone de procédé supercritique (120 ; 220), dans lequel le volume de la zone de procédé pré-supercritique (130 ; 230) est de préférence dans la plage d'environ 0,1 % à environ 20 % du volume de la zone de procédé supercritique (120 ; 220).

8. Appareil selon la revendication 6, dans lequel la zone de procédé pré-supercritique (130) a une forme d'anneau entourant une paroi latérale (122s) de la zone de procédé supercritique (120).

9. Système configuré pour le traitement d'un substrat, le système comprenant :
l'appareil de traitement d'un substrat selon l'une quelconque des revendications 1 à 8, dans lequel :
la zone de procédé pré-supercritique (130 ; 230) est configurée pour recevoir une première alimentation (S1) en fluide supercritique dans celle-ci,
la zone de procédé supercritique (120 ; 220) est configurée pour recevoir une deuxième alimentation (S2) en fluide supercritique dans celle-ci, et
dans lequel la zone de procédé pré-supercritique (130 ; 230) et la zone de procédé supercritique (120 ; 220) sont séparées l'une de l'autre par un ou plusieurs passages (145) configurés entre elles pour fournir une communication fluidique entre la zone de procédé pré-supercritique (130 ; 230) et la zone de procédé supercritique (120 ; 220), et
un dispositif d'alimentation (30) configuré pour fournir les première et deuxième alimentations en fluide supercritique à l'appareil de traitement d'un substrat.

10. Système selon la revendication 9, dans lequel le dispositif d'alimentation est configuré pour fournir la première alimentation (S1) en fluide supercritique avant de fournir la deuxième alimentation (S2) en fluide supercritique.

11. Système selon les revendications 9 et 10, comprenant en outre un condenseur (73) et une pompe (80), le condenseur (73) étant en amont de la pompe (80), dans lequel le fluide supercritique passe à travers le condenseur (73) et la pompe (80).

12. Système selon l'une quelconque des revendications 9 à 11, dans lequel la première alimentation (S1) en fluide supercritique génère un état supercritique dans la zone de procédé supercritique (120 ; 220) et dans lequel le dispositif d'alimentation (30) est configuré pour fournir la deuxième alimentation (S2) en fluide supercritique à la zone de procédé supercritique (120 ; 220) dans l'état dans lequel la zone de procédé supercritique (120 ; 220) est dans l'état supercritique.

13. Système selon l'une quelconque des revendications 9 à 12, dans lequel la première alimentation en fluide supercritique est fournie à travers un premier tuyau d'alimentation (23 ; 10 ; 223) qui est en communication fluidique avec la zone de procédé pré-supercritique, et la deuxième alimentation en fluide supercritique est fournie à travers un deuxième tuyau d'alimentation (24 ; 232) qui est en communication fluidique avec la zone de procédé supercritique.

14. Système selon la revendication 13, dans lequel un des premier et deuxième tuyaux d'alimentation (20) agit en outre comme tuyau d'évacuation pour évacuer les impuretés ou les particules de l'appareil de traitement d'un substrat.

15. Système selon la revendication 13, comprenant en outre un tuyau d'évacuation (26 ; E) en communication avec la zone de procédé pré-supercritique (130 ; 230).

16. Système selon la revendication 9, dans lequel le dispositif d'alimentation (30) est configuré pour fournir successivement les première et deuxième alimentations (S1, S2) en fluide supercritique à l'appareil de traitement d'un substrat.

17. Système selon l'une quelconque des revendications 9 à 16, dans lequel :
la zone de procédé supercritique (120) comprend une surface supérieure (122t) et une surface inférieure (122f) en face l'une de l'autre ; et une paroi latérale (122s) raccordée entre la surface supérieure (122t) et la surface inférieure (122f), et
dans lequel une partie d'un ou plusieurs de la surface supérieure (122t), la surface inférieure (122f) et la paroi latérale (122s) de la zone de procédé supercritique (120) sont en retrait pour définir la zone de procédé pré-supercritique (130).

18. Système selon l'une quelconque des revendications 9 à 16, dans lequel :
la zone de procédé supercritique (120) comprend une surface supérieure (122t) et une surface inférieure (122f) en face l'une de l'autre ; et une paroi latérale (122s) raccordée entre la surface supérieure (122t) et la surface inférieure (122f), et
dans lequel la surface inférieure (122f) de la zone de procédé supercritique (120) est inclinée vers le bas pour former la zone de procédé pré-supercritique (130).

19. Système selon l'une quelconque des revendications 9 à 16, dans lequel :
la zone de procédé supercritique (120) comprend une surface supérieure (122t) et une surface inférieure (122f) en face l'une de l'autre ; une paroi latérale (122s) raccordée entre la surface supérieure (122t) et la surface inférieure (122f), et
dans lequel la zone de procédé pré-supercritique (130) comprend une paroi latérale s'étendant vers le haut depuis la surface inférieure.

20. Système selon la revendication 19, dans lequel la paroi latérale s'étendant vers le haut de la zone de procédé pré-supercritique est inclinée pour former la zone de procédé supercritique.

21. Système selon la revendication 9, dans lequel une partie de la surface inférieure (122f) de la zone de procédé supercritique (120) est en retrait pour définir la zone de procédé pré-supercritique (130) ; une largeur de la zone de procédé pré-supercritique (130) est progressivement réduite vers la zone de procédé supercritique (120) ; et la zone de procédé pré-supercritique (130) comprend un passage (134) ouvert vers la zone de procédé supercritique (120).

22. Système selon la revendication 9, comprenant en outre au moins l'un des suivants : un réservoir tampon (40) fourni entre le dispositif d'alimentation (30) et l'appareil de traitement d'un substrat ; un réservoir de stockage de co-solvant (50) fourni entre le dispositif d'alimentation (30) et l'appareil de traitement d'un substrat ; un dispositif d'alimentation en co-solvant (25a, 55) comprenant un mélangeur (55) mélangeant le co-solvant et le fluide supercritique ; un réservoir de récupération (60) configuré pour stocker un fluide supercritique évacué de l'appareil de traitement d'un substrat ; et un dispositif de régénération (70) configuré pour régénérer un fluide supercritique contenant un contaminant évacué de l'appareil de traitement d'un substrat en un fluide liquide duquel les impuretés sont retirées.

23. Système selon l'une quelconque des revendications 9 à 21, dans lequel l'appareil de traitement comprend une chambre de procédé contenant la zone de procédé supercritique ; et la zone de procédé pré-supercritique occupe une partie d'une région intérieure de la chambre de procédé.

24. Système selon la revendication 23, comprenant en outre : un tuyau d'alimentation principal (21, 22) relié au dispositif d'alimentation (30) pour alimenter la chambre de procédé (10) en fluide supercritique ; et un premier tuyau d'alimentation (23) et un deuxième tuyau d'alimentation (24) divergeant du tuyau d'alimentation principal (20, 22) et reliés à la chambre de procédé (10).
